**Europäisches Patentamt**

**European Patent Office**

**Office européen des brevets**

(19)

(11) Veröffentlichungsnummer: **0 040 392**
**B1**

(12) **EUROPÄISCHE PATENTSCHRIFT**

(45) Veröffentlichungstag der Patentschrift:
15.10.86

(51) Int. Cl.⁴: **H 03 K 4/48,** H 03 K 4/02,
H 04 N 3/16

(21) Anmeldenummer: **81103662.3**

(22) Anmeldetag: **13.05.81**

(54) **Insbesondere monolithisch, vorzugsweise bipolar-monolithisch, integrierte Ablenkschaltung für Kathodenstrahlröhren.**

(30) Priorität: **16.05.80 DE 3018712**

(43) Veröffentlichungstag der Anmeldung:
**25.11.81 Patentblatt 81/47**

(45) Bekanntmachung des Hinweises auf die Patenterteilung:
**15.10.86 Patentblatt 86/42**

(84) Benannte Vertragsstaaten:
**DE FR GB IT NL**

(56) Entgegenhaltungen:
**DE-A-2 019 152**
**DE-B-2 258 864**
**US-A-3 659 282**

**TOUTE L'ELECTRONIQUE, Februar 1977,**
**"Applications et circuits", Seiten 61-65**

(73) Patentinhaber: **Deutsche ITT Industries GmbH,**
**Hans- Bunte- Strasse 19 Postfach 840, D-7800**
**Freiburg (DE)**

(84) Benannte Vertragsstaaten: **DE**

(73) Patentinhaber: **ITT INDUSTRIES INC., 320 Park**
**Avenue, New York, NY 10022 (US)**

(84) Benannte Vertragsstaaten: **FR GB IT NL**

(72) Erfinder: **Freyberger, Laurin C., Dipl.- Ing., Unter**
**Stadt 3, D-7836 Bahlingen a.K (DE)**

(74) Vertreter: **Morstadt, Volker, Dipl.- Ing., c/o**
**Deutsche ITT Industries GmbH**
**Patent/Lizenzabteilung Postfach 840 Hans- Bunte-**
**Strasse 19, D-7800 Freiburg/Brsg. (DE)**

## Beschreibung

Die Erfindung betrifft eine monolithisch integrierte Ablenkschaltung für Kathodenstrahlröhren, die mittels den Merkmalen des Oberbegriffs des Anspruchs 1 ein Sägezahnsignal erzeugt. Diese Mittel sind aus der Zeitschrift "Toute l'Electronique", Februar 1977, Seite 62, unterer Teil, bekannt. Aus der DE-A-20 19 152 ist ferner bekannt, daß mit derartigen Mitteln auch die Abstimmspannung für Kapazitätsdioden von Frequenzsyntheseschaltungen erzeugt werden kann.

Der Erfindung liegt die Aufgabe zugrunde, ausgehend von dem bekannten Prinzip der digitalen Aufbereitung des Sägezahnsignals eine monolithisch integrierte Ablenkschaltung anzugeben, bei der die Kurvenform des Sägezahnsignals in gewünschter Weise, insbesondere zum Zwecke der Tangenskorrektur von Vertikalablenkschaltungen von Fernsehgeräten, beeinflussbar ist. Dies wird mit den im Anspruch 1 angegebenen Mitteln erreicht. Weiterbildungen und vorteilhafte Ausgestaltungen der Erfindung sind in den Unteransprüchen gekennzeichnet.

Die Erfindung wird nun anhand der Figuren der Zeichnung näher erläutert.

Fig. 1 zeigt in Form eines Prinzipschaltbildes eine bekannte Anordnung

Fig. 2 zeigt prinzipschaltbildmäßig eine Ausführungsform der Erfindung,

Fig. 3 zeigt das Schaltbild einer bevorzugten Ausführungsform für das Schieberegister nach der Erfindung und

Fig. 4 zeigt die Anordnung der Einzelelemente des Schieberegisters nach Fig. 3 bei Realisierung als bipolar-monolithisch integrierte Schaltung.

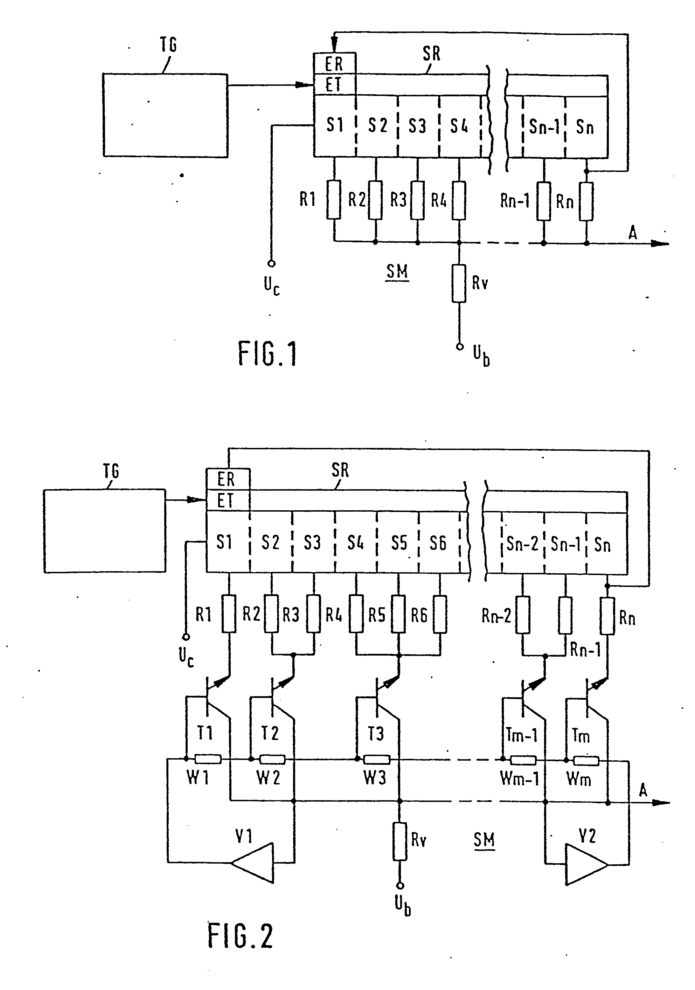

Im Prinzipschaltbild nach Fig. 1 speist der Rechteck-Taktgenerator TG das Schieberegister SR über dessen Takteingang ET. Dieses hat n Stufen, von denen die Stufen S1, S2, S3, S4, Sn-1, Sn gezeigt sind. Der Eingang der ersten Stufe S1 ist der Serien-Signaleingang des Schieberegisters SR und liegt am festen Potential $U_c$. Dieses feste Potential kann einem der beiden Binärsignalpegel H, L entsprechen, so daß einerseits bei jedem Taktimpulswechsel in die erste Stufe S1 immer derselbe Binärsignalpegel, also beispielsweise der H-Pegel, übernommen wird und andererseits dieser Pegel bei jedem Taktimpulswechsel in die nachfolgenden Schieberegisterstufen "weiterwandert". Nach n Taktimpulswechseln befindet sich also in allen Stufen dieser Binärsignalpegel.

Der Rücksetzeingang ER des Schieberegisters SR ist mit dem Ausgang der letzten Stufe Sn verbunden, d.h. wenn in diese Stufe der vom Potential $U_c$ vorgegebene Pegel gelangt, werden alle Stufen des Schieberegisters SR in den Ausgangszustand, also den Zustand mit dem komplementären Binärsignalpegel, zurückversetzt. Im nächsten Zyklus von n Taktsignalwechseln wird das Schieberegister SR wieder von der ersten Stufe S1 aus mit dem Binärsignalpegel sozusagen gefüllt.

Die Zahl n ist so zu wählen, daß sie der Anzahl der Auflösungsschritte der Ablenkperiode entspricht; sie kann also bei einer Ablenkschaltung für Fernsehgeräte entweder der Anzahl der Bildpunkte einer Fernsehbildzeile oder der Zeilenzahl eines Fernsehhalbbildes entsprechen.

Mit den Ausgängen der einzelnen Schieberegisterstufen S1...Sn ist als Summierschaltung SM im Schaltungsbeispiel nach Fig.1 die folgende Widerstandsanordnung angeschlossen. Mit jedem Ausgang der n Stufen S1...Sn ist einer der Widerstände R1...Rn verbunden, deren nicht am Schieberegister liegende Anschlüsse gemeinsam über den Vorwiderstand Rv mit der Betriebsspannung $U_b$ verbunden sind. Der Verbindungspunkt der einzelnen Widerstände R1...Rn mit dem Vorwiderstand Rv stellt den Ausgang A für das die Ablenkmittel der Kathodenstrahlröhre steuernde Sägezahnsignal dar.

Je nach Wahl des Aufbaus des Schieberegisters SR kann es erforderlich sein, zwischen den Ausgängen der einzelnen Stufen S1...Sn und den Widerständen R1...Rn einen elektronischen Schalter vorzusehen, der gewährleistet, daß der eine der beiden Binärsignalpegel am Ausgang der Schieberegisterstufen für alle Stufen möglichst gleich und möglichst in der Nähe des Potentials des Schaltungsnullpunkts liegt. Für linear verlaufende Flanken des zu erzeugenden Sägezahnsignals sind die Widerstandswerte der einzelnen Widerstände R1...Rn untereinander gleich zu wählen.

Eine derartige Schaltung ist in der Offenlegungsschrift DE-A- 20 19 152, insbesondere in der Fig. 1, dargestellt. Jeder Stufe eines Schieberegisters ist ein Transistor zugeordnet, deren Emitteranschlüsse gemeinsam an Masse liegen. Die Basisanschlüsse dieser Transistoren sind jeweils mit dem Ausgang einer Schieberegisterstufe und die Kollektoren jeweils mit einem der Widerstände einer Summierschaltung verbunden. Alle Widerstände der Summierschaltung sind an der von dem Transistoranschluß wegweisenden Seite gemeinsam über einen Vorwiderstand an die Versorgungsspannung angeschlossen. Das Potential des Verbindungspunktes der einzelnen Widerstände mit dem Vorwiderstand ist weiteren Schaltungsteilen zugeführt. In Fig. 2 der Offenlegungsschrift DE-A- 20 19 152 sind die Emitteranschlusse der genannten Transistoren wie in Fig. 1 ebenfalls miteinander verbunden und führen somit ein gemeinsames Bezugspotential, dessen Wert im Gegensatz zur Fig.1 der genannten Offenlegungsschrift nicht mehr der des festen Schaltungsnullpunktes (= Masse) ist, sondern sich aus dem Spannungsabfall der von den Transistoren geschalteten Ströme an einem gegen ein negatives Potential geschalteten Widerstand ergibt.

Die Summierschaltung SM besteht im Ausführungsbeispiel nach Fig. 2 ebenfalls aus den Widerständen R1...Rn und dem Vorwiderstand Rv, zusätzlich sind jedoch noch die Transistoren T1...Tm und der aus den Widerständen W1....Wm bestehende Spannungsteiler sowie die beiden Spannungsverstärker VI, V2 vorgesehen. Das Prinzip der Anordnung nach Fig. 2 besteht darin, daß pro Widerstand R1...Rn höchstens ein Transistor T1....Tm vorgesehen ist, dessen Emitter bzw. Source mit dem zugeordneten Widerstand und dessen Kollektor bzw. Drain mit den Kollektoren bzw. Drains der anderen Transistoren verbunden ist, welcher gemeinsame Verbindungspunkt über den Vorwiderstand Rv wiederum an der Betriebsspannung U_b liegt. Ferner liegen die Basen bzw. Gates der Transistoren T1...Tm an dem erwähnten Spannungsteiler aus den Widerständen W1....Wm und zwar so, daß in der Reihenfolge der einzelnen Transistoren TI, T2, T3, Tm-1, Tm die zugehörige Basis jeweils an aufeinanderfolgenden Abgriffen des Spannungsteilers angeschlossen ist. So liegt also beispielsweise die Basis des Transistors T2 am Verbindungspunkt der Widerstände W1, W2, die Basis des Transistors T3 am Verbindungspunkt der Widerstände W2, W3 und die Basis des Transistors Tn am Verbindungspunkt der Widerstände Wm-1, Wm.

Dieses Grundprinzip ist im Ausführungsbeispiel nach Fig. 2 insofern modifiziert, als nicht jedem der Widerstände R1...Rn ein entsprechender Transistor zugeordnet ist, sondern daß mindestens zwei aufeinanderfolgende Widerstände über einen gemeinsamen Transistor am entsprechenden Spannungsteilerabgriff liegen. So sind den beiden Widerständen R2, R3 der Transistor T2, den Widerständen R4, R5, R6 der Transistor T3 und den Widerständen Rn-2, Rn-1 der Transistor Tm-1 zugeordnet. Es ist ersichtlich, daß die Laufzahl m der Transistoren T1...Tm und der Widerstände W1...Wm nur für den erstgenannten Fall gleich der Laufzahl n der Widerstände R1...Rn ist, in dem jedem Widerstand ein Transistor zugeordnet ist.

Die Kurvenform des Sägezahnsignals wird nun sowohl durch die Wahl der Widerstandswerte der Widerstände W1...Wm als auch durch die Wahl der Potentiale an den Enden des Spannungsteilers und deren Verlauf vorgegeben. Im Ausführungsbeispiel der Fig. 2 ist gezeigt, daß die beiden Enden über die beiden Spannungsverstärker V1, V2 mit dem gemeinsamen Kollektorpotential der Transistoren T1...Tm verbunden ist. Als derartige Spannungsverstärker können beispielsweise übliche Emitterfolgerstufen - die Spannungsverstärkung ist dabei selbstverständlich etwas kleiner als eins- oder geeignete andere Spannungsverstärker, z.B. entsprechend geschaltete Operationsverstärker,verwendet werden. Die Wahl dieser Einflußmöglichkeiten auf die Kurvenform des Sägezahnsignals hängt von den Kenngrößen der verwendeten Bildröhre und Ablenkmittel ab und kann dem Fachmann überlassen bleiben.

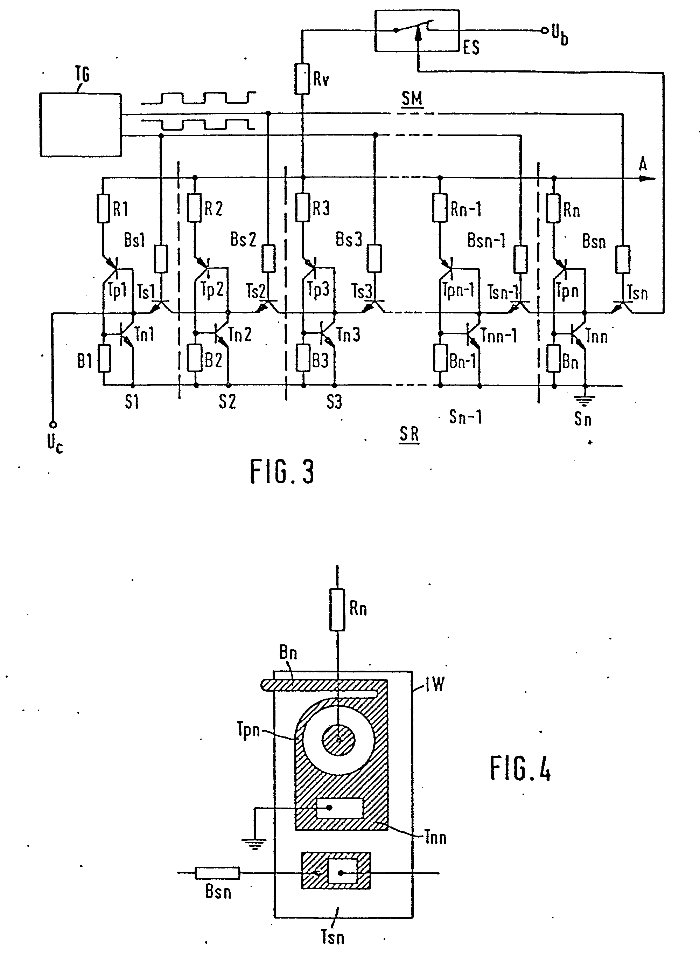

In Fig. 3 ist das Schaltbild einer Realisierungsmöglichkeit für die einzelnen Schieberegisterstufen gezeigt, wenn dieses als bipolar-monolithisch integrierte Schaltung realisiert werden soll. Im wesentlichen besteht die Schieberegisterstufe S1...Sn aus einer thyristorartigen Anordnung zweier komplementärer Transistoren Tn1, Tp1...Tnn, Tpn. Dem npn-Transistor Tn1...Tnn, dessen Emitter am Schaltungsgt, ist dabei der Basiswiderstand B1...Bn der parallel zur Basis-Emitter-Strecke liegt. des pnp-Transistors Tp1...Tpn ist der jeweilige Ausgang und somit mit dem jeweiligen Widerstand R1...Rn verbunden, die über den Vorwiderstand Rv wiederum an der Betriebsspannung U_b liegen. Zur bereits erwähnten Rücksetzung des Schieberegisters SR ist als Möglichkeit in Fig. 3 gezeigt, die Betriebsspannung U_b über einen elektronischen Schalter ES dem Vorwiderstand Rv zuzuführen, der während des erwähnten Auffüllens des Schieberegisters geschlossen ist und lediglich, wenn das Eingangssignal die letzte Stufe erreicht hat, kurzzeitig geöffnet wird. Der Steuereingang des elektronischen Schalters ES ist daher im Ausführungsbeispiel nach Fig. 3 von der letzten Stufe Sn entsprechend gesteuert.

Zu jeder Stufe S1...Sn gehört ferner noch der Steuertransistor Ts1...Tsn, dessen Emitter mit dem Kollektor des npn-Transistors und der Basis des pnp-Transistors jeder Stufe und dessen Kollektor mit dem gleichen Verbindungspunkt der nächsten Stufe verbunden ist; die Emitter-Kollektor-Strecke des Steuertransistors verbindet also die "Gate-Elektroden" der thyristorartigen Anordnungen untereinander.

Der erwähnte Basis-Kollektor-Verbindungspunkt der ersten Stufe S1 liegt an dem erwähnten konstanten Potential U_c. Jedem Steuertransistor Ts1...Tsn ist schließlich noch der Basisvorwiderstand Bs1...Bsn zugeordnet, über die die einzelnen Stufen S1...Sn mit dem Rechtecktaktgenerator TG verbunden sind. Dieses geschieht im Ausführungsbeispiel nach Fig. 3 in der Weise, daß der Rechtecktaktgenerator TG zwei gegenphasige Taktsignale abgibt, d.h. die beiden sind gegeneinander um 180° phasenverschoben. Die ungeradzahligen Stufen S1, S3, Sn-1 liegen dabei an dem einen Taktsignal und die geradzahligen Stufen S2, Sn am anderen Taktsignal.

In Fig. 4 ist schließlich noch gezeigt, wie bei bipolarmonolithischer Realisierung die einzelne Schieberegisterstufe im Halbleiterkörper der integrierten Schaltung angeordnet werden kann. Die beiden komplementären Transistoren Tnn, Tpn, der Basiswiderstand Bn sowie der Steuertransistor Tsn sind dabei jeweils in einer einzigen Isolierwanne IW angeordnet, deren Material sowohl die Kollektorzonen des Steuertransistors Tsn und des npn-Transsistors Tnn als auch die Basiszone des lateralen pnp-Transistors Tpn bildet. Die schraffiert gezeichneten Zonen stellen beim Steuertransistor Tsn dessen Basiszone, beim npn-Transistor Tnn ebenfalls die Basiszone und beim pnp-Transistor Tpn dessen Kollektorzone dar. Die innerhalb des schraffierten Gebiets liegende nichtschraffierte Fläche veranschaulicht beim Steuertransistor Tsn und beim npn-Transistor Tnn jeweils deren Emitterzonen und beim lateralen pnp-Transistor Tpn dessen Basiszone. Innerhalb dieser als Kreisring unschraffiert gezeichneten Zone befindet sich die wieder schraffiert gezeichnete Emitterzone des lateralen pnp-Transistors Tpn. Ferner ist in Fig. 4 noch gezeigt, daß der Basiswiderstand Bn des npn-Transistors Tnn als Fortsatz von dessen Basiszone ausgebildet werden kann.

Bei der erwähnten Anwendung der Ablenkschaltung nach der Erfindung in Fernsehgeräten, bei denen der Bildsynchronimpuls durch Frequenzteilung aus dem Zeilensynchronimpuls mittels Zählern abgeleitet wird, ist es besonders vorteilhaft, das Schlieberegister zugleich als derartigen Zähler zu verwenden. Dann ist zusätzlich zu der in den Fig. 1 bis 3 gezeigten Beschaltung des Schieberegisters noch eine geringfügige zusätzliche Decodierschaltung bezüglich einiger der letzten Stufen des Schieberegisters erforderlich, wie dies bei Zählern für den genannten Zweck bereits bekannt ist.

Der Vorteil der Erfindung ist darin zu sehen, daß Schieberegister und Summierschaltung im Vergleich zu der eingangs genannten bekannten Anordnung mit wesentlich weniger Einzelbauelementen auskommen, so daß sich der bei integrierter Realisierung erforderliche Platz auf dem Halbleiterkristall in Grenzen hält und bei vorgegebener Kristallfläche weitere Funktionen eines Fernsehgerätes darauf untergebracht werden können. Ferner ist die Ablenkschaltung nach der Erfindung sowohl zur Realisierung mittels der bereits erwähnten bipolaren Integrierungstechnik als auch zur Integrierung in der bekannten MOS-Technik geeignet.

**Patentansprüche**

1. Monolithisch integrierte Ablenkschaltung für Kathodenstrahlröhren, die mittels von einem Rechteck-Taktgenerator (TG) gesteuerten Digitalschaltungen und Decodern ein Sägezahnsignal erzeugt, wobei
- ein Rechteck-Taktgenerator (TG) am Takteinang (ET) eines n-stufigen Schieberegisters (SR) liegt, dessen Serien-Signaleingang auf festem Potential ($U_c$) liegt, wobei mit n die Anzahl der Auflösungsschritte der Ablenkperiode, also z.B. die Anzahl der Bildpunkte einer Fernsehbildzeile oder die Zeilenzahl eines Fernsehhalbbildes, bezeichnet ist, wobei ferner
- der Decoder eine Summierschaltung (SM) bestehend aus n mit den n Ausgängen des Schieberegisters (SR) verbundenen Widerständen (R1...Rn) und einem Vorwiderstand (Rv) ist, über den die n Widerstände (R1...Rn) gemeinsam an Betriebsspannung ($U_b$) liegen, und als Ausgang (A) für das Sägezahnsignal zur Ansteuerung der Ablenkmittel der Verbindungspunkt des Vorwiderstandes (Rv) mit den n Widerständen (R1...Rn) dient, und wobei
- der Rücksetzeingang (Er) des Schieberegisters (SR) von der letzten Schieberegisterstufe (Sn) gesteuert ist, dadurch gekennzeichnet, daß zwischen die n Widerstände (R1...Rn) der Summierschaltung (SM) und Betriebsspannung ($U_b$) Transistoren (T1...Tm) geschaltet sind, derart, daß jedem Einzelwiderstand oder mehreren aufeinanderfolgenden Widerständen gemeinsam ein Transistor zugeordnet ist, dessen Emitter bzw. Source mit dem zugehörigen Widerstand bzw. den zugehörigen Widerständen (R1...Rn) und dessen Kollektor bzw. Drain mit den Kollektoren bzw. Drains der entsprechenden anderen Transistoren verbunden ist, und daß an die Basen bzw. Gates der Transitoren (T1...Tm) jeweils ein den zeitlichen Verlauf des Sägezahnsignals bestimmendes Potential angelegt ist.

2. Monolithisch integrierte Ablenkschaltung nach Anspruch 1, dadurch gekennzeichnet, daß die Basen der einzelnen Transistoren (T1...Tn) an aufeinanderfolgenden Abgriffen eines ohmschen Spannungsteilers (W1...Wm) liegen, dessen beide Enden mit dem jeweiligen Ausgang zweier vom gemeinsamen Kollektor- bzw. Drainpotential der Transistoren (T1...Tm) gesteuerten Spannungsverstärker (V1, V2) verbunden sind.

3. Monolithisch integrierte Ablenkschaltung nach Anspruch 1 oder 2, dadurch gekennzeichnet, daß mindestens zwei aufeinanderfolgenden Widerständen (R2, R3; R4, R5, R6; Rn-2; Rn-1) ein Transistor (T2, T3, Tn-1) zugeordnet ist.

4. Monolithisch integrierte Ablenkschaltung nach einem der Ansprüche 1 bis 3, dadurch gekennzeichnet, daß sie in Bipolartechnik realisiert ist, daß die Stufen (S1...Sn) des Schieberegisters (SR) jeweils aus zwei komplementären, eine Thyristorstruktur bildenden Transistoren (Tnl, Tp1...Tnn, Tpn) mit einem zusammen mit dem Emitter des npn-Transistors (Tn1...Tnn) am Schaltungsnullpunkt liegenden Basiswiderstand (B1...Bn) des npn-Transistors und aus einem Steuertransistor (Ts1...Tsn) mit Basisvorwiderstand (Bs1...Bsn), dessen Emitter am Verbindungspunkt von Basis des pnp-Transistors (Tp1...Tpn) und Kollektor des npn-Transistors (Tn1...Tnn) derselben Stufe und dessen Kollektor mit dem gleichen Verbindungspunkt der nächstfolgenden Stufe verbunden ist, bestehen, daß der Emitter des pnp-Transistors (Tp1...Tpn) jeder Stufe (S1...Sn) mit einem der Widerstände (R1...Rn) verbunden ist und daß die Basisvorwiderstände (Bs2,Bsn) der gerad- bzw. der ungeradzahligen Stufen (S2, Sn; S1, S3, Sn-1) des Schieberegisters (SR) an jeweils einem Ausgang des Rechteck-Taktgenerators (TG) für zwei zueinander gegenphasige Taktsignale liegen.

5. Monolithisch integrierte Ablenkschaltung nach Anspruch 4, dadurch gekennzeichnet, daß die beiden komplementären Transistoren (Tnn, Tpn), der Basiswiderstand (Bn) und der Steuertransistor (Tsn) jeder Stufe (S1...Sn) des Schieberegisters (SR) in einer gemeinsamen Isolierwanne (IW) des Halbleiterkörpers der monolithisch integrierten Schaltung angeordnet sind (Fig. 4).

6. Monolithisch integrierte Ablenkschaltung nach einem der Ansprüche 1 bis 5, dadurch gekennzeichnet, daß zur Erzeugung des Vertikalablenksignals von Fernsehgeräten, bei denen der Bildsynchronimpuls aus dem Zeilensynchronimpuls mittels Zählern abgeleitet ist, das Schieberegister (SR) zugleich als derartiger Zähler dient.

## Claims

1. Monolithic integrated deflection circuit for cathode-ray tubes, which, with the aid of digital circuits controlled by a square-wave clock-pulse generator (TG), and decoders, generates a sawtooth signal, wherein
- a square-wave clock-pulse generator (TG) is connected to the clock-pulse input (ET) of an n-stage shift register (SR) whose series-signal input is applied to a fixed potential $(U_c)$, with n indicating the number of resolution steps of the deflecting period, hence e.g. the number of picture points in one television-picture line, or the number of lines of one television field, wherein moreover
- the decoder is a summing (integrating) circuit (SM) consisting of n resistors (R1...Rn) which are connected to the n outputs of said shift register (SR), and of one series resistor (Rv) across which said n resistors (Rl... Rn) are jointly applied to the supply voltage (Ub), and the point connecting said series resistor (Rv) to said n resistors (Rl... Rn) is used as the sawtooth-signal output (A) for controlling the deflection means, and wherein
- the reset input (ER) of said shift register (SR) is controlled by the last shift-register stage (Sn),
characterized in that between said n resistors (R1...Rn) of said summing (integrating) circuit (SM) and the supply voltage (Ub) a number of transistors (T1...Tm) is inserted, i.e. in such a way that either to each individual resistor or in common to several successively following resistors one transistor each is assigned, with the emitter or source thereof being connected to the associated resistor(s) (R1...Rn), and with the collector or drain thereof being connected to the collectors or drains of the corresponding other transistors respectively, and that to the base or gate electrodes of said transistors (T1...Tm) there is applied a potential respectively determining the course of said sawtooth signal as a function of time.

2. A monolithic integrated deflection circuit as claimed in claim 1, characterized in that the base electrodes of the individual transistors (T1...Tn) are applied to successively following tapping points of an ohmic voltage divider (W1...Wm), the two ends of which being connected to the respective output of two voltage amplifiers (V1, V2) which are controlled by the common collector or drain potential of the respective one of said transistors (T1...Tm).

3. A monolithic integrated deflection circuit as claimed in claim 1 or 2, characterized in that one transistor (T2, T3, Tn-1) is associated with at least two successively following resistors (R2, R3; R4, R5, R6; Rn-2) Rn-1).

4. A monolithic integrated deflection circuit as claimed in one of claims 1 to 3, characterized in that it is realized in accordance with the wellknown bipolar technique, that the stages (S1...Sn) of said shift register (SR) each consist of two complementary transistors (Tn1, Tpl... Tnn, Tpn) forming a thyristor structure, with a base resistor (B1...Bn) of the npn-transistor being applied, together with the emitter of the npn-transistor (Tn1...Tnn), to the zero point of the circuit, and of a control transistor (Ts1...Tsn) comprising a base series resistor (Bs1... Bsn), whose emitter is applied to the point connecting both the base of the pnp-transistor (Tp1...Tpn) and the collector of the npn-transistor (Tn1...Tnn) of the same stage, and whose collector is applied to the same connecting point of the successively following stage, that the emitter of said pnp-transistor (Tp1...Tpn) of each stage (S1...Sn) is connected to one of said resistors (R1...Rn), and that the base series resistors (Bs2, Bsn) of the even- or odd-numbered stages (S2, Sn; S1, S3, Sn-1) of said shift register (SR) are each respectively applied to one output of said square-wave clock-pulse generator (TG) for two clock signals being oppositely in phase with respect to one another.

5. A monolithic integrated deflection circuit as claimed in claim 4, characterized in that said two complementary transistors (Tnn, Tpn), said base resistor (Bn) and said control transistor (Tsn) of each stage (S1...Sn) of said shift register (SR)are disposed in one common insulating island (IW) of the semiconductor body of said monolithic integrated circuit (Fig.4).

6. A monolithic integrated deflection circuit as claimed in any one of claims 1 to 5, characterized in that for generating the vertical deflecting signal in television receivers in which the picture synchronizing pulse is derived from the line synchronizing pulse with the aid of counters, said shift register (SR) simultaneously serves as such a counter.

## Revendications

1. Circuit de balayage, intégré monolithique, pour tube cathodique qui au moyen de circuits numériques commandés par un générateur d'impulsions d'horloge rectangulaires (TG) et de décodeurs, produit un signal en dents de scie dans lequel
- un générateur d'impulsions d'horloge rectangulaires (TG) est relié à l'entrée d'horloge (ET) d'un registre à décalage à n étages (SR), dont l'entrée série de signal est reliée à un potentiel fixe (Uc), n étant le nombre de pas de résolution de la période de balayage, c'est-à-dire, par exemple, le nombre de points d'image d'une ligne de balayage d'une image de télévision ou le nombre de lignes d'une demiimage de télévision et, de plus,
- le décodeur comporte un circuit de sommation (SM) qui est constitué de n résistances (R1...Rn) reliées aux n sorties du registre à décalage, et d'une résistance série (Rv), par laquelle les n résistances (R1...Rn) sont reliées ensemble à une tension d'alimentation (Ub), le point de liaison de la résistance série (Rv) avec les n résistances (R1...Rn) faisant fonction de sortie (A) pour le signal en dents de scie, et
- l'entrée de remise à zéro (Er) du registre à décalage (SR) est commandé par le dernier étage (Sn) du registre à décalage, caractérisé en ce que
des transistors (T1...Tm) sont montés entre les n résistances (R1...Rn) et la tension d'alimentation (Ub), de façon que chaque résistance individuelle, ou plusieurs résistance consécutives, soit chacune reliées à un transistor, dont l'émetteur, respectivement la source, est relié à la résistance qui lui est attribuée, respectivement aux résistances qui lui sont attribuées, et dont le collecteur, respectivement le drain, est relié aux collecteurs, respectivement aux drains des autres transistors correspondants, et en ce que aux bases, respectivement aux grilles, des transistors est relié un potentiel déterminant la variation dans le temps du signal en dents de scie.

2. Circuit de balayage ingégré monolithique selon la revendication 1 caractérisé en ce que les bases de chacun des transistors individuels (T1...Tn) sont reliés à des points consécutifs de prélèvement d'un diviseur de tension ohmique (W1...Wm) dont les deux extrémités sont reliées respectivement aux sorties correspondantes de deux amplificateurs (V1, V2) de la tension commune de collecteur respectivement de drain, des transistors (T1...Tm).

3. Circuit de balayage intégré monolithique selon l'une des revendications 1 ou 2, caractérisé en ce que au moins deux résistances consécutives (R2, R3, R4, R5, R6; Rn-2; Rn-1) sont attribués à un transistor (T2, T3, Tn-1).

4. Circuit de balayage intégré monolithique selon l'une des revendications 1 à 3, caractérisé en ce qu'il est réalisé en technique bipolaire, en ce que chacun des étages (S1...Sn) du registre à décalage (RS) est constitué de deux transistors complémentaires (Tn1,Tp1...Tnn,Tpn) montés en structure de thyristors avec une résistance de base (B1...Bn) du transistor npn reliée, ainsi que l'émetteur du transistor npn (Tn1...Tnn) au point d'alimentation de tension nulle, et un transistor de commande (Ts1...Tsn) muni d'une résistance série de base (Bs1...Bsn), dont l'émetteur est relié au point de liaison de la base du transistor pnp (Tp1...Tpn) et du collecteur du transistor npn (Tn1...Tnn) du même étage, et dont le collecteur est relié au point de liaison similaire de l'étage suivant, en ce que l'émetteur du transistor pnp (Tp1...Tpn) de chaque étage (S1...Sn) est relié à une résistance (R1...Rn) et en ce que les résistances de base (Bs2, Bsn) des étages pairs, respectivement des étages impairs, (S2, Sn; S1, S3, Sn-1) du registre à décalage (SR) sont reliées chacune à l'une des sorties du générateur d'impulsions d'horloge rectangulaires pour deux signaux communs d'horloge en opposion de phase.

5. Circuit de balayage intégré monolithique selon la revendication 4, caractérisé en ce que les deux transistors complémentaires (Tnn,Tpn), la résistance de base (Bn) et le transistor de commande (Tsn) de chacun des étages (S1...Sn) du registre à décalage (SR) sont disposés dans une cuvette isolée (IW) du corps semiconducteur du circuit intégré monolithique (Fig. 4).

6. Circuit de balayage intégré monolithique selon l'une des revendications 1 à 5, caractérisé en ce que le registre à décalage fait en même temps fonction de compteur pour la production du signal de déviation verticale d'un récepteur de télévision, dans lequel l'impulsion de synchronisation d'image est dérivée par comptage à partir de l'impulsion de synchronisation ligne.

FIG.1

FIG.2

FIG.3

FIG.4